# EUROPEAN PATENT APPLICATION

(11) **EP 4 668 312 A2**
(43) Date of publication of application: **24.12.2025**
(21) Application number: 25179032.5
(22) Date of filing: 27.05.2025
(51) Int. Cl.: H01J 37/09, H01J 37/305

(54) **INHOMOGENEOUS D-SHAPED FOCUSED ION BEAMS**

(30) Priority: 29.05.2024 US 202418677701
(71) Applicant: FEI Company, Hillsboro, OR 97124-5793 (US)
(72) Inventor: GLEDHILL, Galen, Los Angeles (US)
(74) Representative: Boult Wade Tennant LLP

(57) **Abstract**

Methods and apparatus 600 for producing a charged particle beam 606 with a charged particle beam source 604 and directing the charged particle beam along a beam axis 608 of a charged particle beam column 602 to a target 610, directing the charged particle beam through an elongated aperture 618 that is situated by an offset with respect to the beam axis, and focusing the beam to the target to produce an asymmetric intensity cross-section for the beam, wherein the cross-section has a sharp intensity edge at the target based on the offset elongated aperture.

## Description

### FIELD

The field is charged particle beam systems and methods of producing charged particle beams.

### BACKGROUND

Multi-lens systems have been used to image system apertures to a sample or employed aperture projection techniques to produce intensity distributions at the sample. However, such approaches are typically unsuitable in applications involving highly focused beams or they produce an unsuitably low-density and broad area intensity distribution. A need remains for improves techniques for producing desirable beam characteristics and systems for employing the same.

### SUMMARY

Disclosed apparatus and methods can create asymmetric shaped intensity profiles with sharp edges (e.g., "D-shaped") for charged particle beams (electron beams, ion beams, etc.) by using offset, elongated apertures.

According to an aspect of the disclosed technology, methods include producing a charged particle beam with a charged particle beam source and directing the charged particle beam along a beam axis of a charged particle beam column to a target, directing the charged particle beam through an elongated aperture that is situated by an offset with respect to the beam axis, and focusing the beam to the target to produce an asymmetric intensity cross-section for the beam, wherein the cross-section has a sharp intensity edge at the target based on the offset elongated aperture.

According to another aspect of the disclosed technology, apparatus include a charged particle beam source configured to produce a charged particle beam in a charged particle beam column and to direct the charged particle beam along a beam axis of the charged particle beam column to a target, an elongated aperture situated to receive the charged particle beam, wherein the elongated aperture is offset with respect to the beam axis, and an objective lens configured to focus the beam to the target to produce an asymmetric intensity cross-section for the beam, wherein the cross-section has a sharp edge at the target based on the offset elongated aperture.

The foregoing and other objects, features, and advantages of the disclosed technology will become more apparent from the following detailed description, which proceeds with reference to the accompanying figures.

### BRIEF DESCRIPTION OF THE DRAWINGS

The patent or application file contains at least one drawing executed in color. Copies of this patent or patent application publication with color drawings will be provided by the Office upon request and payment of the necessary fee.
FIG. 1 is a plan view of a circular aperture and a corresponding intensity distribution (in cross-section) of a beam at a target produced after propagation through the circular aperture.
FIG. 2 is a plan view of an elliptical aperture and a corresponding intensity distribution (in cross-section) of a beam at a target produced after propagation through the elliptical aperture.
FIG. 3 is a plan view of an offset elliptical aperture and a corresponding intensity distribution (in cross-section) of a beam at a target produced after propagation the offset elliptical aperture.
FIG. 4 is a cross-sectional intensity distribution of a beam focused at a target and produced with a circular aperture.
FIG. 5 is a graph of side intensity distributions of beams produced with a circular aperture and an offset elliptical aperture.
FIG. 6 is a schematic of a charged particle beam microscope system.
FIGS. 7A-7I are intensity distributions of beam cross-sections produced with a circular aperture.
FIGS. 8A-8I are intensity distributions of beam cross-sections produced with an on-axis elliptical aperture.
FIGS. 9A-9I are intensity distributions of beam cross-sections produced with an off-axis elliptical aperture.
FIG. 10 is a flowchart of a method of selecting characteristics for a charged particle system that produce sharp edged beams.
FIG. 11 is a flowchart of a method of milling a sample with a shaped beam.

### DETAILED DESCRIPTION

Disclosed examples can address problems and difficulties associated with increasing milling performance of a focused-ion-beam (FIB) by increasing an amount of current in a given diameter on a milling target. Examples can provide a sharp edge along which the beam intensity drops rapidly over a short distance (e.g., perpendicular to the edge). This can allow more precise material processing of a target with charged particle beams like FIBs or electron beams. In many disclosed examples, an aperture used to define the beam is an elongated aperture, such as an elliptical aperture. The aperture is configured to be offset in relation to a beam axis and the elongated aperture can be used to increase the amount of current in the beam while minimizing an increase in the beam size in the narrow axis of the aperture.

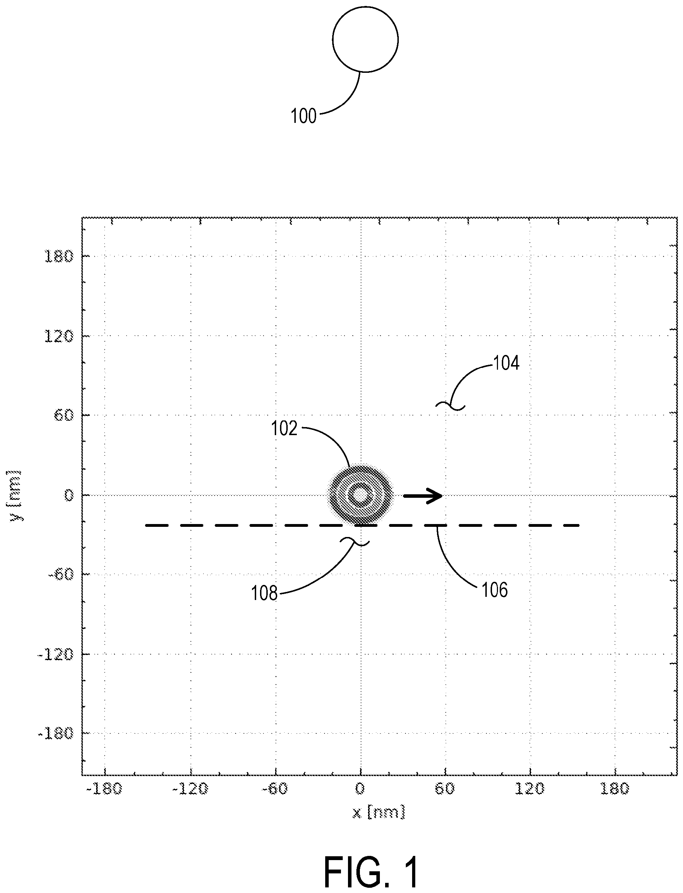

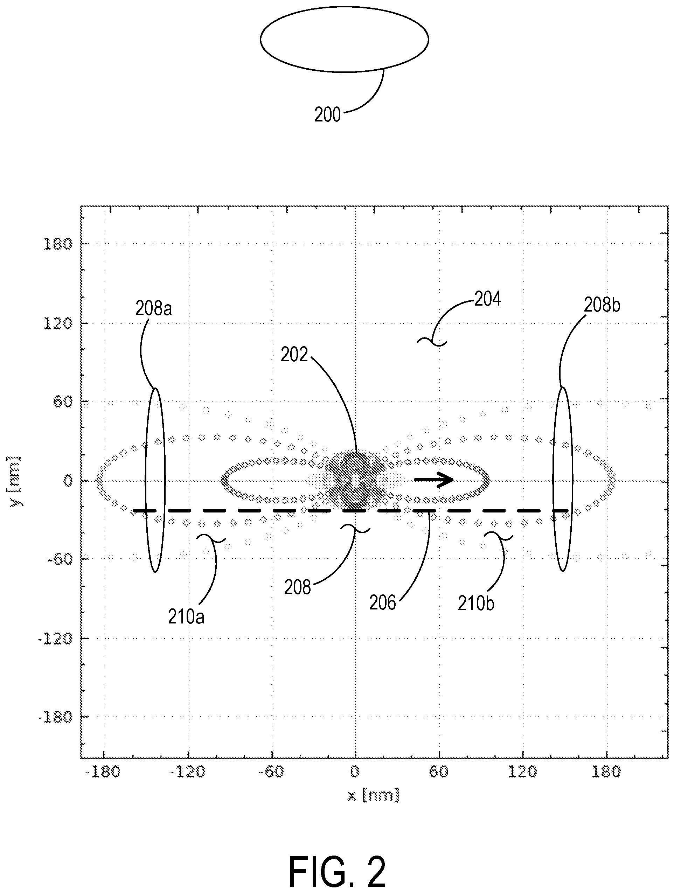

FIG. 1 shows a commonly used circular aperture 100 that can be situated in a charged particle beam column (e.g., FIB, e-beam, etc.), alongside an intensity profile cross-section of a charged particle beam 102 that is produced at a surface of a target 104 using the circular aperture 100. In milling examples, the beam 102 can be scanned across the surface, e.g., here in the left-right x-direction (shown by a right-facing arrow) to remove material from the target 104 and form a cutting edge 106, forming a target region 108 adjacent to the cutting edge 106 that can be minimally affected by the beam 102. FIG. 2 shows an elliptical aperture 200 that can replace the circular aperture 100 in the charged particle beam column, along with a corresponding intensity profile of its charged particle beam cross-section 202 at a target 204. The elliptical aperture 200 can allow a significant increase in the current, e.g., twice as much or more contained in a similar beam cross-section at the target 204. The beam 202 can also be scanned along a direction in milling examples which can define a cutting edge 206 and a region 208 adjacent to the cutting edge 206 where material is minimally affected.

While an elongated aperture aligned with a beam axis (e.g., with a center point of the ellipse coinciding with a central axis of the beam) can work well for low currents because the image angles are relatively small and the spherical aberration does not significantly degrade the quality of the beam at the target, at high currents larger image angles are present and spherical aberration causes an undesirable "bow-tie" effect. Such an effect can manifest as beam tails 208a, 208b that degrade the performance of the beam at the target 204. These bow-tie lobes generally come from a coupling of the extension of the aperture in one axis causes broadening of the beam in the other axis. As can be seen, the lobes 208a, 208b introduce a small but significant amount of energy in regions 210a, 210b of the surface of the target 204 adjacent to the cutting edge 206, thereby extending beam current to regions where such energy is undesirable. For example, in many milling and processing applications even small amounts of current past the cutting edge 206 will degrade the process target because of damage to the target outside the region that is being removed. The lobes can be minimized in various ways, such as using additional correction lenses that can compensate for or cancel out the lobes 208a, 208b. However, such techniques can be costly and introduce additional complexities into the microscope column and control over the beam.

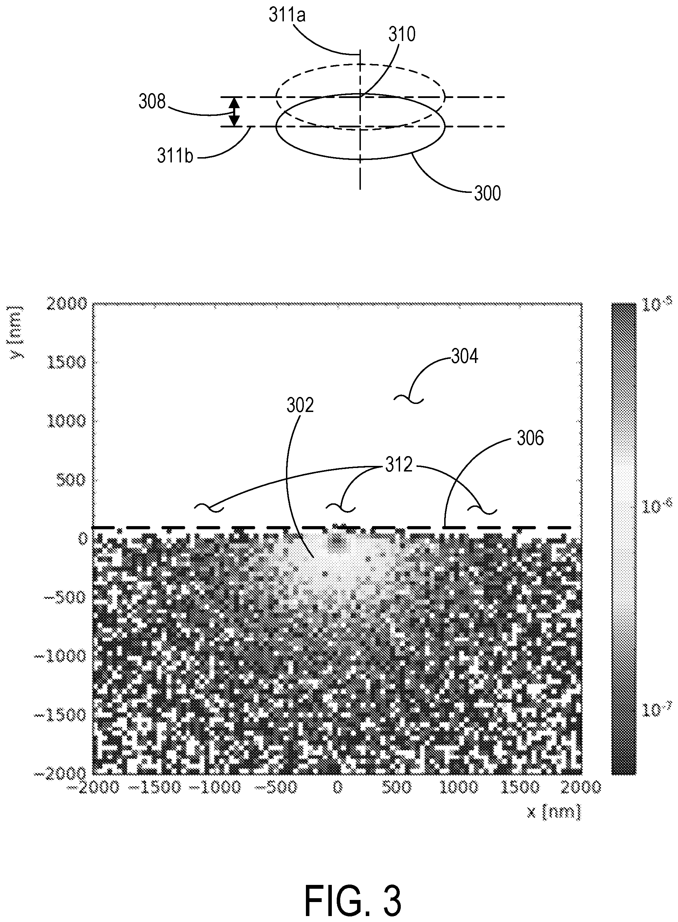

In accordance with examples of the disclosed technology, FIG. 3 shows an example of offset elongated aperture 300 (here, elliptical) that can be used in charged particle beam columns to produce a charged particle beam 302 at a surface of a target 304. The aperture 300 is offset a small distance 308 along a direction perpendicular to the elongation, away from a position 310 corresponding to a center beam axis of the charged particle beam column. In some examples, the elongated aperture 300 can be elliptical, with associated major and minor axes 311a, 311b. The offset can be along a direction of the minor axis 311a. As can be seen from the intensity cross-section of the beam 302 at the surface of the target 304, based on the elongated and offset characteristics of the aperture 300, the beam 302 can be formed at the target 304 with asymmetric characteristics, e.g., such that the intensity diminishes rapidly on a side of the beam 302. This can allow for the precise formation of the cutting edge 306 as the beam is scanned in a selected direction aligned with the cutting edge 306 (left-right in FIG. 3) without significant beam current being deposited in a region 312 adjacent to the cutting edge 306. In representative examples, an additional corrector that might otherwise be needed to remove undesirable bowties is no longer needed due to the offset 308.

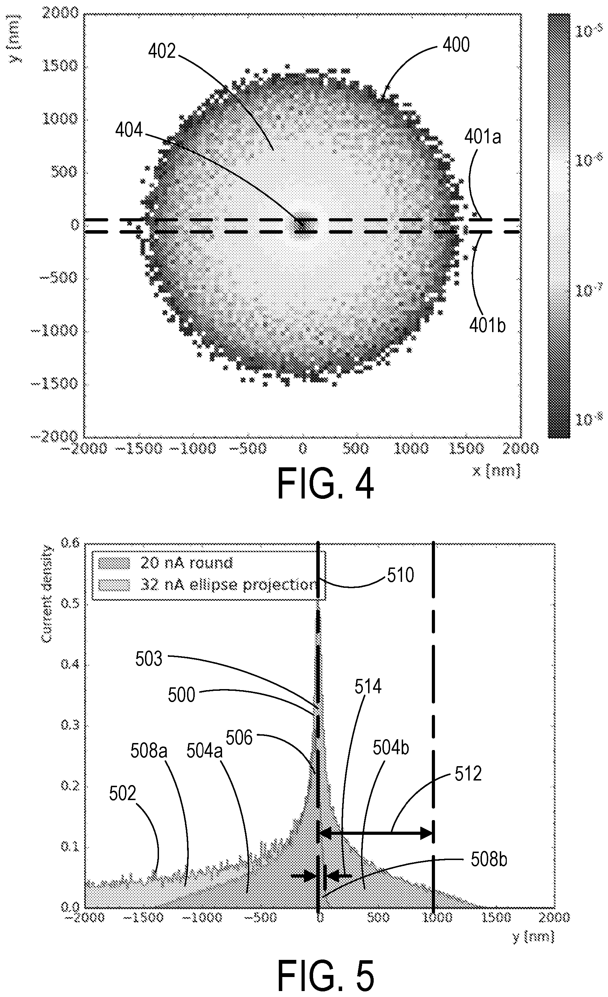

The offset 308 can be chosen in relation to other variables to optimize the current distribution that is created at the target 304. In selected examples, the offset 308 is selected in relation to a column magnification and an elongation ratio of the aperture 300. The aperture and column variables can be selected to minimize one or more parameters of the beam 302 at the target 304. For example, FIG. 4 shows a typical round beam 400 produced with a circular, non-offset aperture, such as aperture 100. The round beam 400 is consistent with a FIB source object size of approximately 50 nm (approximate distance between dashed lines 401a, 401b shown). However, the spherical aberration of the beam 400 causes significant beam energy 402 to be rotationally disposed about the center 404 of the beam 400. FIG. 5 shows side cross-sectional beam intensity profiles produced at a target for different beams 500, 502. The beam 500 is produced using a circular aperture and can correspond to the beam 400 in FIG. 4. Like the beam 400, the beam 500 has a center portion 503 with a large current density but beam 500 includes significant beam energy in tail sections 504a, 504b. In contrast, the beam 502 is produced with an offset elliptical aperture (in this case, using a 1:3 aspect ratio). The beam 502 can correspond to the beam 302 in FIG. 3 produced with aperture 30, and therefore beam 502 has a significant central portion 506 and includes asymmetric tail portions 508a, 508b. The portions 506, 508a, 508b are consistent with the profile of beam 302 in FIG. 3, e.g., with the lower half of the beam 302 in FIG. 3 corresponding to the left-hand tail portion 508a and the upper half of the beam 302 in FIG. 3 corresponding to the right-hand tail portion 508b. The shifting of the aperture 300 by the offset 308 can operate to clip out beam rays with large image angles which can then reduce or move the tail 508b. Various offsets can be used, e.g., between about 0.25 times and 2 times the diameter of beam diameter at the aperture, 0.1 and 5 times, 0.5 and 1.5 times, etc. The elongation of the elongated aperture 300 can also take various values, e.g., with aspect ratios of 1:1.5, 1:2, 1:3, 1:5, 1:10, etc.

Disclosed examples can have aperture and column characteristics selected in relation to each other to provide an optimization over a quantifiable characteristic which describes the tail 508b. One such metric can be termed an "asymmetric" full-width 90 (FW90) or asymmetric full-width 50, which can correspond to the distance of a tail (such as tail 508b) that contains 90% of the current as measured only from a central peak, such as line 510 centered on central portions 503, 506. The metric is asymmetric because a complementary FW90 on the opposing side of the central peak is often many times larger. Such a metric can specifically capture this one-sided sharpness of an asymmetric beam such as beam 502. Thus, in selecting values for the aperture and column components in relation to each other, the distance which captures 90% of the current as measured from the peak out to a side can be minimized while the opposing FW90 can be allowed to remain the same or grow larger. As shown the asymmetric FW90 distance 512 for the beam 500 is relatively large (~ 1000 nm) while the asymmetric FW90 distance 514 for the beam 502 is considerably smaller (~ 50 nm). Thus, even though the current density might be lower for the beam 502 at its peak (e.g., in its central portion 506) than the beam 500, the asymmetric FW90 is many times smaller. Example asymmetric FW90s for the sharp edge of the cross-section can vary from beam to beam and system to system, with values including less than or equal to 100 nm, 50 nm, 20 nm, 10 nm, 5 nm, 2 nm, or 1 nm, etc.

The edge of the beam 502 is typically relatively straight (as can be seen for the intensity profile 302 and the corresponding cutting edge 306), and so when the beam 502 is rastered similar to a round beam (like beam 500) along the direction of the straight edge, the beam 502 mills a pattern in a target surface and produces a well-defined edge. In examples where the intensity edge that is formed is somewhat curved, the edge generally bends towards the beam 502 rather than away (convex rather than concave), which also allows formation of a well-defined edge through scanning. The shape of the beam 302, 502 can also be optimized in relation to characteristics of the targeted sample to provide a highest throughput at a fixed damage threshold, allowing faster milling with less damage in transmission electron microscope (TEM) sample preparation.

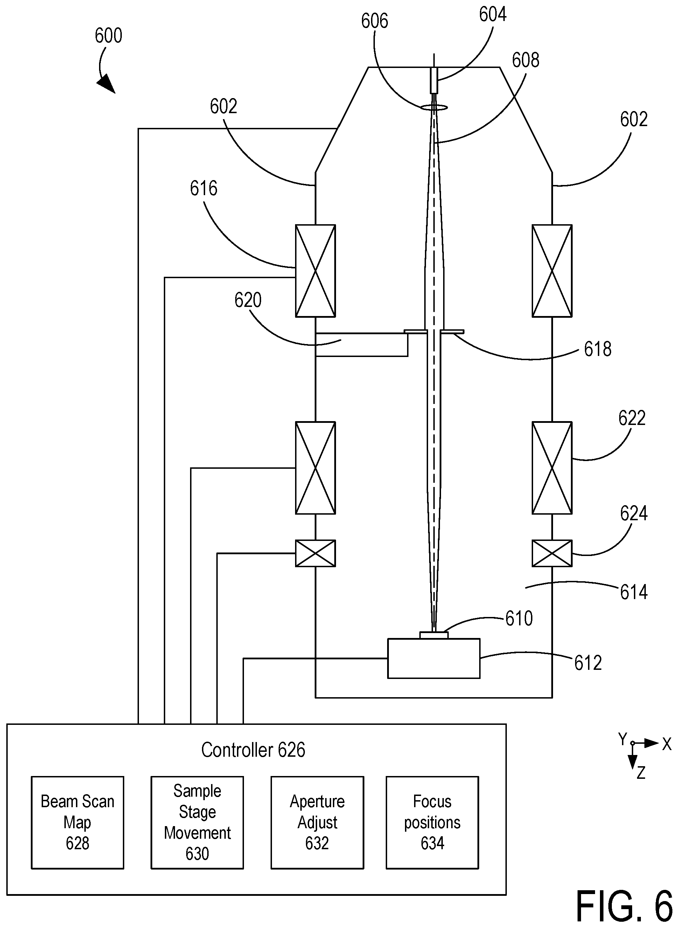

FIG. 6 is an example charged particle beam microscope 600 that includes a charged particle beam column 602. The microscope 600 can include FIBs, SEMs, STEMs, TEMs, as well as multi beam/column systems, such as systems with a large main electron column and a smaller FIB column arranged at an angle with respect to the electron column and aimed towards a common sample chamber. For convenience of illustration, only one column is shown. The column 602 can include a charged particle beam source 604 configured to produce and direct a charged particle beam 606 along a column beam axis 608. The column 602 can include an arrangement of column components that manipulate the beam 606 and direct it towards a target 610 coupled to a stage 612 that can support the target 610 and provide other functions, such as movement, temperature control, etc. The target 610 and stage 612 are typically situated in an environmentally controlled chamber 614, e.g., controlling the presence of gas species, pressure, temperature, etc.

The column components can include a condenser lens 616 situated to collect and condense the beam 606 after divergence from the beam source 604. The condenser lens typically includes one or more electrostatic and/or magnetostatic lens components. In representative examples, the condenser lens 616 is configured to collimate the beam 606, e.g., so that that beam 606 propagates with minimal convergence/divergence. In further examples, the condenser lens 616 can be configured to converge the beam 606 and/or bring the beam 606 to an intermediate focus. In many examples, the intermediate focus is avoided or unneeded. For example, because the object size is very small (e.g., ~50 nm), it is often unnecessary to further reduce the object size or, thus providing more of a 1:1 magnifier.

An elongated aperture 618 can be situated proximate the condenser lens 616, e.g., immediately following the condenser lens 616 or after the beam is collimated. In some examples, the elongated aperture 618 can be situated immediately before the condenser lens. In many examples, the location of the aperture 618 is selected to be maximally upstream in the column 602 which can reduce the beam current as much as possible as fast as possible to minimize coulombic interactions. Thus, while allowing the beam to diverge can be a consideration for aperture placement, limiting beam current can be a higher priority as the beam is being continuously degraded in the high current region before the beam reaches the aperture 618. In representative example, the elongated aperture 618 is not situated at an image plane or focal plane of the lens 618 or other lenses of the column 602, as may be used in aperture imaging/projection techniques.

The elongated aperture 618 is offset from the beam axis 608 in the X and/or Y directions, so that a center of the elongated aperture 618 is not coaxial with the beam axis 608. As discussed elsewhere herein, the offset can be used to produce an asymmetric intensity cross-section for the beam 606 at the target 610 with a sharp edge. The cross-section can correspond to a center cross-section of the beam along a direction of the offset. For example, where the elongated aperture 618 is an elliptical aperture, the offset can be along a direction of a minor axis of the elliptical aperture which generally extends perpendicular to the major axis and corresponding elongation direction of the aperture 618. Thus, a scanning of the beam 606 across the target along a direction perpendicular to the offset (e.g., along the direction of the elongation of the aperture) can produce a well-defined cutting edge with minimal damage to portions of the target that are adjacent to the sharp edge. The aperture 618 can be coupled to a support 620. In some examples, the support 620 can include a movement stage that can be configured to change a positioning of the aperture 618, e.g., by rotating the aperture 618 about the axis 608. The rotation can adjust a positioning of the beam edge at the target 610. Other movements can be applied such as variations in the offset, swapping out and replacing with other apertures, other angles (e.g., relative to the X-Y plane), etc.

The surrounding portion defining the aperture 618 can be made of a thin foil such as molybdenum, though other materials can be used. Aperture dimensions are typically on the order of tens to hundreds of microns. For example, an elliptical aperture example can be 200 um by 300 um (an aspect ratio of 1.5). An example offset can be on a similar order of the aperture size, such as 100 microns in the case of a 200 um by 300 um aperture. In general, the offset can be on the order of the beam diameter.

The column 602 can also include an objective lens 622 situated downstream from the condenser lens 616 and aperture 618 to receive the beam 606 and to focus the beam to the target 610. In many examples, the column 602 can include a beam scanner 624 that can be situated to direct the beam 606 relative to the target 610, e.g., by raster scanning a path across a surface of the target 610. The beam scanner 624 can include, e.g., one or more beam deflection coils.

A system controller 626 (which can be part of or separate from a larger control system or environment of the system 600) can be configured to control various components of the charged particle beam system 600. For example, the controller 626 can be coupled to the beam source 604 to control emission of the beam 606 and characteristics of the emitted beam (e.g., source selection, beam current, timing, pulse generation, etc.). The controller 626 can also be coupled to the condenser lens 616, objective lens 622, beam scanner 624, and other lens and beam control components, to control beam characteristics at the target 610, e.g., focus position, aberration correction, magnification, deflection position, etc. For example, the controller 626 can included a beam scan map 628 stored in memory that can be used to guide the beam 606 during various material processes, such as FIB milling.

The controller 626 can be further coupled to the stage 612 to control movement and positioning of the target 610 relative to the beam 606. In many examples, the stage movements 630 can be stored in memory and executed during an ion milling process flow. In some examples, the controller 626 can also be coupled to the movement stage coupled to the support 620 to control a selection, movement, and/or positioning of the aperture 618 relative to the beam 606, e.g., to change an angle or other characteristics of a beam edge of the beam 606 at the target. Selected aperture adjustments 632 can be stored in a memory as part of a workflow, such as part of a milling process.

In many examples, as the beam 606 is brought to a focus position at the target 610 using the objective lens 622 to produce an intensity cross-section with a sharp edge that may be desirable for various processes, certain other focus positions above and/or below the selected focus position (e.g., corresponding to certain positions of a through-focus series) can produce undesirable intensity cross-sections, e.g., cross-sections with a significant (or even substantial) amount of energy past the intended edge, that could damage surfaces of the target 610. Focus positions 634 (or positions to avoid) can be stored in a memory so that undesirable intensity cross-sections at the surface of the target 610 can be avoided.

In general, the elongated aperture (e.g., 1.5 to 5x) 618 can be offset to remove lobes of the intensity cross-section at the target 610 and the magnification of the condenser lens can be selected to balance aberrations against spot size at the target 610 to deliver a sharp-edged beam. Thus, in some examples, the controller 626 can be configured to provide adjustments of the sharp-edged characteristics of the beam 606 by adjusting the offset of the aperture 618 (or the aperture itself to change an elongation extent or shape) and the magnification provided by the lens components of the column 602.

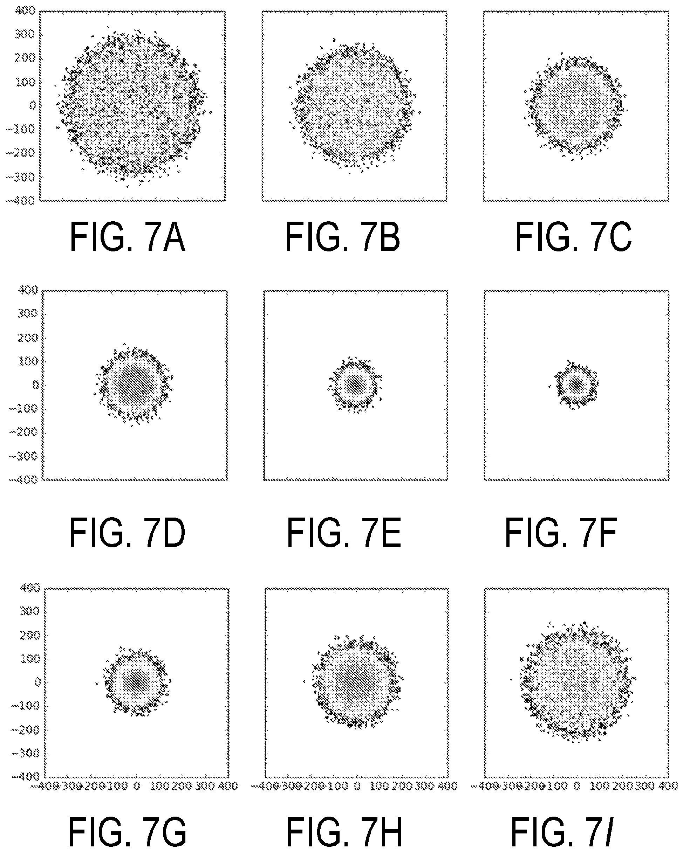

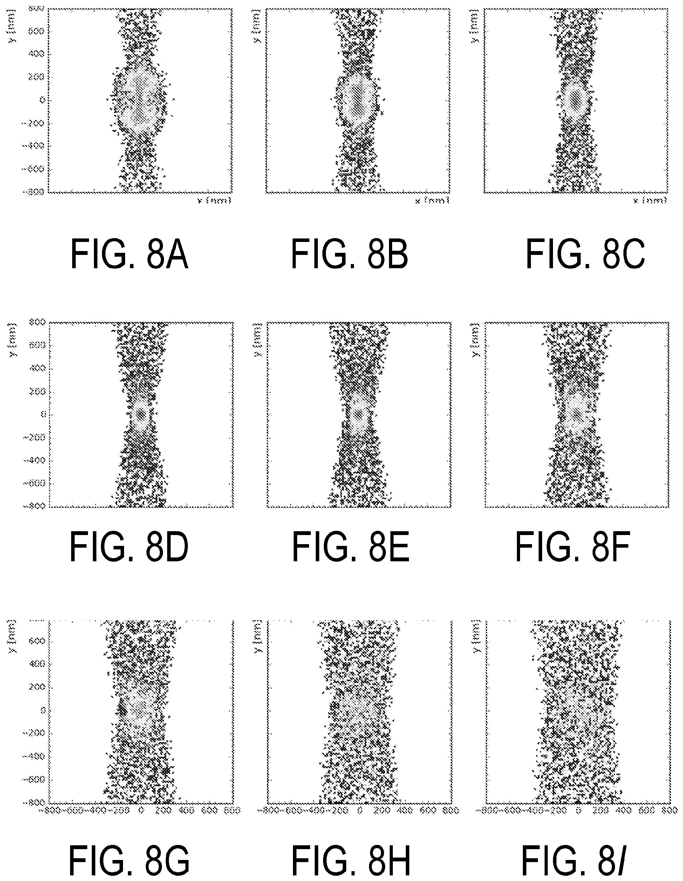

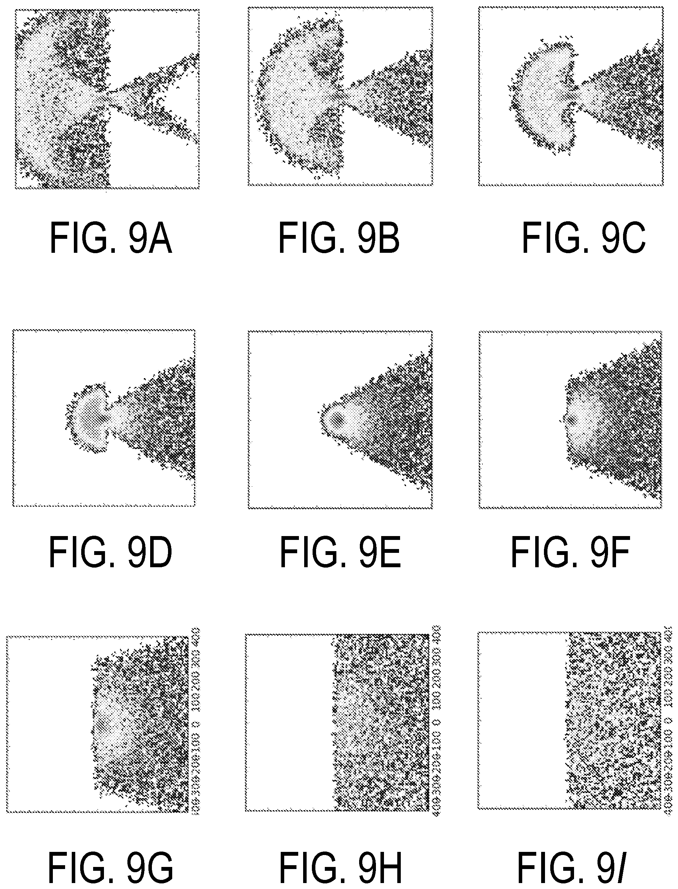

FIGS. 7A-9I show three through-focus image series for beams produced at a target using a circular aperture (FIGS. 7A-7I), an elliptical aperture (FIGS. 8A-8I), and an offset elliptical aperture (FIGS. 9A-9I). The progression in each image series shows the cross-section of the respective beam as the strength of an objective lens is varied. Thus, the through-focus series can be understood as a variation in the focus adjustment of the beam, and images of the beam with each of these focus settings, e.g., as slices in space through the z-axis or an adjustment of the focus control. FIGS. 7A-7I show beam cross-sections that are round and remain round through the through-focus series. FIGS. 8A-8I show beam cross-sections that relatively linear or hour-glass-like in the vertical direction, with some variation in the high intensity regions on opposing ends of the through-focus series. Significant portions of the beam energy can extend past the left or right edges of the central high-intensity regions.

FIGS. 9A-9I show beam cross-sections that vary significantly throughout the through-focus series, in accordance with many disclosed examples. As shown, a beam focus is achieved in FIG. 9F and the beam cross-sections in FIGS. 9F-9G have well-defined beam edges on the left side of the beam cross-section, with little to no ion energy being deposited to the left of the edge. Through the focus-series, several through-focus positions exist (see FIGS. 9A-9E) where some or most of the beam energy arrives to the left of the edge shown in FIGS. 9F-9G. Such focus positions can be avoided in accordance with many process examples herein. As discussed hereinabove, elongating the beam defining aperture can result in large tails for beams with large spherical aberration and the offset of the aperture can be used to clip off high image angle rays. Disclosed examples use offset elongated apertures together with suitable column magnification and aperture aspect ratio to produce asymmetric, sharp-edged beams. The amount of defocus can also be optimized in relation to offset, elongation, and magnification, such that the sharp-edge is produced at a selected focus position of the beam. Typically, the selected focus position corresponds to a spot or in-focus position though selected defocus positions can be selected and optimized in relation to offset, elongations, and magnification, in some examples. As shown in FIGS. 9A-9I, the sharp-edge can be produced in beams at a beam focus and various defocus positions or ranges of defocus positions can be specifically avoided.

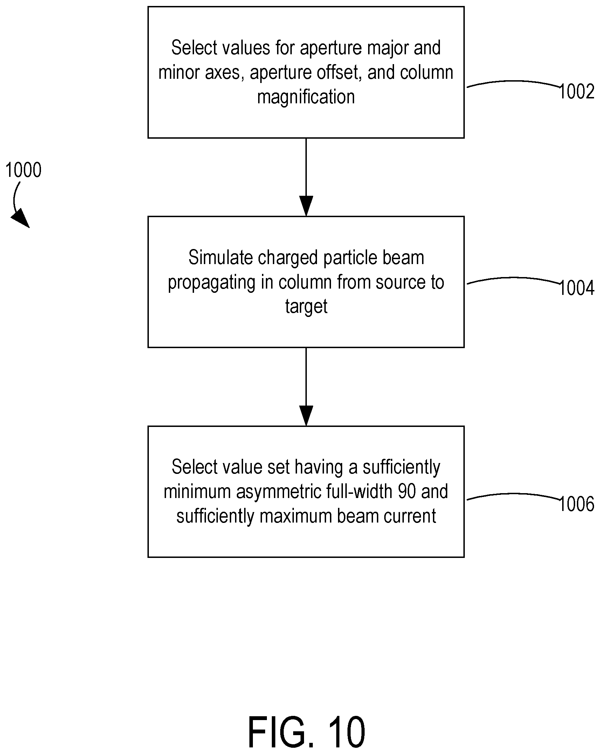

FIG. 10 is an example process 1000 that can be used to select system parameter values that can produce asymmetric, sharp-edged beam intensity cross-sections for a charged particle beam at a target. At 1002, values can be selected for aperture major and minor axes, aperture offset, and column magnification. The existence of an offset can tend to degrade beam performance, many values for the minor/major axis can be unsuitable and result in degraded performance, and many values for column magnification can degrade performance. Thus, many combinations can result in poor or undesirable simulation results. However, some sets can produce sharp edges that can exhibit superior performance to a round beam, e.g., with superior beam milling characteristics and an absence of energy deposition in undesired areas.

At 1004, simulations can be performed for the charged particle beam propagating in a charged particle beam column from a particle beam source to a target, using the selected values and a set of variations of the selected values at 1002. For example, aperture offsets can be increased and decreased by incremental values or percentages, aperture aspect ratios can be increased and decreased by incremental values or percentages, and column magnifications can be increased and decreased by incremental values or percentages. The results of the simulations can be analyzed to select parameter sets that exhibit favorable beam characteristics and optionally further refined against additional degrees of freedom. At 1006, values can be selected having a sufficiently minimum asymmetric full-width 90 and sufficiently maximum beam current for the intensity cross-section of the beam at the target. The values can be stored in memory and used in milling or other sample processing workflows.

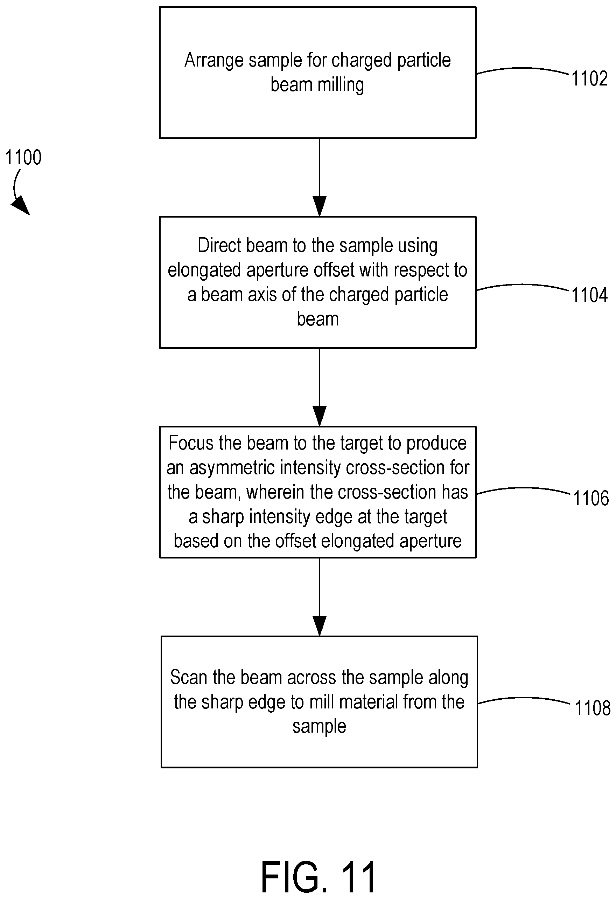

FIG. 11 is an example milling process 1100 that can be used with various charged particle beams and samples. At 1102, a sample can be arranged for charged particle beam milling. The sample is typically arranged in an environmentally controlled chamber on a sample stage. At 1104, a charged particle beam can be directed to the sample by directing the beam through an offset elongated aperture. The beam can be collected with a condenser lens and, at 1106, focused to the target, e.g., using an objective lens, to form an asymmetric beam intensity distribution at the sample having a sharp edge. At 1108, the beam can be scanned across the sample along a direction corresponding to the sharp edge to mill material from the sample.

### General Considerations

As used in this application and in the claims, the singular forms "a," "an," and "the" include the plural forms unless the context clearly dictates otherwise. Additionally, the term "includes" means "comprises." Further, the term "coupled" does not exclude the presence of intermediate elements between the coupled items.

The systems, apparatus, and methods described herein should not be construed as limiting in any way. Instead, the present disclosure is directed toward all novel and non-obvious features and aspects of the various disclosed embodiments, alone and in various combinations and sub-combinations with one another. The disclosed systems, methods, and apparatus are not limited to any specific aspect or feature or combinations thereof, nor do the disclosed systems, methods, and apparatus require that any one or more specific advantages be present or problems be solved. Any theories of operation are to facilitate explanation, but the disclosed systems, methods, and apparatus are not limited to such theories of operation.

Although the operations of some of the disclosed methods are described in a particular, sequential order for convenient presentation, it should be understood that this manner of description encompasses rearrangement, unless a particular ordering is required by specific language set forth below. For example, operations described sequentially may in some cases be rearranged or performed concurrently. Moreover, for the sake of simplicity, the attached figures may not show the various ways in which the disclosed systems, methods, and apparatus can be used in conjunction with other systems, methods, and apparatus. Additionally, the description sometimes uses terms like "produce" and "provide" to describe the disclosed methods. These terms are high-level abstractions of the actual operations that are performed. The actual operations that correspond to these terms will vary depending on the particular implementation and are readily discernible by one of ordinary skill in the art.

In some examples, values, procedures, or apparatus' are referred to as "lowest", "best", "minimum," or the like. It will be appreciated that such descriptions are intended to indicate that a selection among many used functional alternatives can be made, and such selections need not be better, smaller, or otherwise preferable to other selections.

Portions of disclosed techniques and processes can be embodied as software or firmware instructions carried out by one or more controllers, such as a digital computer. For instance, control over any of the disclosed beam processing or system parameter selection techniques can be performed by a computer or other computing hardware (e.g., an ASIC or FPGA) that is part of a charged particle microscope system. The charged particle microscope system can be connected to or otherwise in communication with the various system components to perform ion milling or other materials processing workflows. The computer can be a computer system comprising one or more processors (processing devices) and tangible, non-transitory computer-readable media (e.g., one or more optical media discs, volatile memory devices (such as DRAM or SRAM), or nonvolatile memory or storage devices (such as hard drives, NVRAM, and solid state drives (e.g., Flash drives)). The one or more processors can execute computer-executable instructions stored on one or more of the tangible, non-transitory computer-readable media, and thereby perform any of the disclosed techniques. For instance, software for performing any of the disclosed embodiments can be stored on the one or more volatile, non-transitory computer-readable media as computer-executable instructions, which when executed by the one or more processors, cause the one or more processors to perform any of the disclosed techniques. Scan maps and beam edge alignments of asymmetric beams can be coordinated to mill or process targets and can be stored in the one or more tangible, non-transitory computer-readable storage media.

### Additional Examples

The following are additional examples of the disclosed technology.

Example 1 is a method, including producing a charged particle beam with a charged particle beam source and directing the charged particle beam along a beam axis of a charged particle beam column to a target, directing the charged particle beam through an elongated aperture that is situated by an offset with respect to the beam axis, and focusing the beam to the target to produce an asymmetric intensity cross-section for the beam, wherein the cross-section has a sharp intensity edge at the target based on the offset elongated aperture.

Example 2 includes the subject matter of Example 1, wherein the sharp edge is defined such that a full-width of 90% of a tail of the beam intensity extending from a position of a peak of the beam intensity is less than or equal to 100 nm, 50 nm, 20 nm, 10 nm, 5 nm, 2 nm, or 1 nm.

Example 3 includes the subject matter of any of Examples 1-2, wherein the elongated aperture is an elliptical aperture and the offset is along a direction of a minor axis of the elliptical aperture.

Example 4 includes the subject matter of any of Examples 1-3, wherein the elliptical aperture has an ellipticity between 3 and 5.

Example 5 includes the subject matter of any of Examples 3-4, wherein an amount of elongation of the elliptical aperture, the offset of the aperture, and a column magnification applied to the beam, are selected in relation to each other to produce the sharp edge.

Example 6 includes the subject matter of any of Examples 1-5, wherein the offset is greater than 0.25 times a diameter of the beam at the aperture and less than or equal to 2 times the diameter of the beam at the aperture.

Example 7 includes the subject matter of any of Examples 1-6, and further includes directing the charged particle beam through a condenser lens, wherein the aperture is situated proximate the condenser lens and the aperture is not situated at an intermediate focus plane of the charged particle beam column.

Example 8 includes the subject matter of any of Examples 1-7, and further includes scanning the beam across the target along a direction of the sharp edge.

Example 9 includes the subject matter of Example 8, wherein the scanning the beam comprises milling the target to remove material from the target and form a sharp material edge on the target at a position of the sharp edge of the beam cross-section.

Example 10 includes the subject matter of any of Examples 1-9, and further includes controlling the focusing the beam to the target by preventing focusing the beam to a range of focus positions at the target associated with significant beam energy present past the sharp edge, wherein the range of focus positions is axially near a position or range of focus positions that produce the sharp edge.

Example 11 is an apparatus, comprising a charged particle beam source configured to produce a charged particle beam in a charged particle beam column and to direct the charged particle beam along a beam axis of the charged particle beam column to a target, an elongated aperture situated to receive the charged particle beam, wherein the elongated aperture is offset with respect to the beam axis, and an objective lens configured to focus the beam to the target to produce an asymmetric intensity cross-section for the beam, wherein the cross-section has a sharp edge at the target based on the offset elongated aperture.

Example 12 includes the subject matter of Example 11, wherein the sharp edge is defined such that a full-width of 90% of a tail of the beam intensity extending from a position of a peak of the beam intensity is less than or equal to 100 nm, 50 nm, 20 nm, 10 nm, 5 nm, 2 nm, or 1 nm.

Example 13 includes the subject matter of any of Examples 11-12, wherein the elongated aperture is an elliptical aperture and the offset is along a direction of a minor axis of the elliptical aperture.

Example 14 includes the subject matter of Example 13, wherein the elliptical aperture has an ellipticity between 3 and 5.

Example 15 includes the subject matter of any of Examples 13-14, wherein an amount of elongation of the elliptical aperture, the offset of the aperture, and a column magnification applied to the beam, are selected in relation to each other to produce the sharp edge.

Example 16 includes the subject matter of any of Examples 11-15, wherein the offset is greater than 0.25 times the diameter of the beam at the aperture and less than or equal to 2 times the diameter of the beam at the aperture.

Example 17 includes the subject matter of any of Examples 11-16 and further includes a condenser lens arranged between the charged particle beam source and the objective lens and situated to receive the charged particle beam, wherein the aperture is situated proximate the condenser lens and the aperture is not situated at an intermediate focus plane of the charged particle beam column.

Example 18 includes the subject matter of any of Examples 11-17 and further includes a beam scanner coupled to the charged particle beam column and configured to scan the beam across the target along a direction of the sharp edge.

Example 19 includes the subject matter of Example 18, wherein the beam scanner is configured to scan the beam to mill the target to remove material from the target and form a sharp material edge on the target at a position of the sharp edge of the beam cross-section.

Example 20 includes the subject matter of any of Examples 11-19, and further includes a controller coupled to the objective lens that prevents the objective lens from focusing the beam to a range of focus positions at the target associated with significant beam energy present past the sharp edge, wherein the range of focus positions is axially near a position or range of focus positions that produce the sharp edge.

Example 21 includes a computer readable medium including processor-executable instructions for performing any of the Examples 1-10.

In view of the many possible embodiments to which the principles of the disclosed technology may be applied, it should be recognized that the illustrated embodiments are only representative examples and should not be taken as limiting the scope of the disclosure. Alternatives specifically addressed in these sections are merely exemplary and do not constitute all possible alternatives to the embodiments described herein. For instance, various components of systems described herein may be combined in function and use. We therefore claim all that comes within the scope of the appended claims.

## Claims

1. A method, comprising:
producing a charged particle beam with a charged particle beam source and directing the charged particle beam along a beam axis of a charged particle beam column to a target;
directing the charged particle beam through an elongated aperture that is situated by an offset with respect to the beam axis; and
focusing the beam to the target to produce an asymmetric intensity cross-section for the beam, wherein the cross-section has a sharp intensity edge at the target based on the offset elongated aperture.

2. The method of claim 1, wherein the sharp edge is defined such that a full-width of 90% of a tail of the beam intensity extending from a position of a peak of the beam intensity is less than or equal to 100 nm, 50 nm, 20 nm, 10 nm, 5 nm, 2 nm, or 1 nm.

3. The method of claim 1, wherein the elongated aperture is an elliptical aperture having an ellipticity between 3 and 5, and the offset is along a direction of a minor axis of the elliptical aperture.

4. The method of claim 3, wherein an amount of elongation of the elliptical aperture, the offset of the aperture, and a column magnification applied to the beam, are selected in relation to each other to produce the sharp edge.

5. The method of claim 1, wherein the offset is greater than 0.25 times a diameter of the beam at the aperture and less than or equal to 2 times the diameter of the beam at the aperture.

6. The method of claim 1, further comprising, directing the charged particle beam through a condenser lens, wherein the aperture is situated proximate the condenser lens and the aperture is not situated at an intermediate focus plane of the charged particle beam column.

7. The method of claim 1, further comprising scanning the beam across the target along a direction of the sharp edge, and wherein the scanning the beam comprises milling the target to remove material from the target and form a sharp material edge on the target at a position of the sharp edge of the beam cross-section.

8. The method of claim 1, further comprising controlling the focusing the beam to the target by preventing focusing the beam to a range of focus positions at the target associated with significant beam energy present past the sharp edge, wherein the range of focus positions is axially near a position or range of focus positions that produce the sharp edge

9. An apparatus, comprising:
a charged particle beam source configured to produce a charged particle beam in a charged particle beam column and to direct the charged particle beam along a beam axis of the charged particle beam column to a target;
an elongated aperture situated to receive the charged particle beam, wherein the elongated aperture is offset with respect to the beam axis; and
an objective lens configured to focus the beam to the target to produce an asymmetric intensity cross-section for the beam, wherein the cross-section has a sharp edge at the target based on the offset elongated aperture.

10. The apparatus of claim 9, wherein the elongated aperture is an elliptical aperture having an ellipticity between 3 and 5, and the offset is along a direction of a minor axis of the elliptical aperture, and wherein an amount of elongation of the elliptical aperture, the offset of the aperture, and a column magnification applied to the beam, are selected in relation to each other to produce the sharp edge.

11. The apparatus of claim 9, wherein the sharp edge is defined such that a full-width of 90% of a tail of the beam intensity extending from a position of a peak of the beam intensity is less than or equal to 100 nm, 50 nm, 20 nm, 10 nm, 5 nm, 2 nm, or 1 nm, and wherein the offset is greater than 0.25 times the diameter of the beam at the aperture and less than or equal to 2 times the diameter of the beam at the aperture.

12. The apparatus of claim 9, further comprising a condenser lens arranged between the charged particle beam source and the objective lens and situated to receive the charged particle beam, wherein the aperture is situated proximate the condenser lens and the aperture is not situated at an intermediate focus plane of the charged particle beam column.

13. The apparatus of claim 9, further comprising a beam scanner coupled to the charged particle beam column and configured to scan the beam across the target along a direction of the sharp edge.

14. The apparatus of claim 13, wherein the beam scanner is configured to scan the beam to mill the target to remove material from the target and form a sharp material edge on the target at a position of the sharp edge of the beam cross-section.

15. The apparatus of claim 9, further comprising a controller coupled to the objective lens that prevents the objective lens from focusing the beam to a range of focus positions at the target associated with significant beam energy present past the sharp edge, wherein the range of focus positions is axially near a position or range of focus positions that produce the sharp edge.
